# FASCICULE DE BREVET EUROPEEN

(11) **EP 2 667 205 B1**
(45) Date de publication et mention de la délivrance du brevet: **14.01.2015**
(21) Numéro de dépôt: 13305487.4
(22) Date de dépôt: 15.04.2013
(51) Int. Cl.: G01R 15/18, H01F 38/30

(54) **Capteur de courant mixte et procédé de montage dudit capteur**
Mischstromsensor und Montageverfahren dieses Sensors
Mixed current sensor and method for fitting said sensor

(30) Priorité: 21.05.2012 FR 1201432
(43) Date de publication de la demande: 27.11.2013
(73) Titulaire: Schneider Electric Industries SAS, 92500 Rueil-Malmaison (FR)
(72) Inventeur: Loglisci, David, 38050 GRENOBLE Cedex 09 (FR)
(74) Mandataire: Tripodi, Paul

(56) Documents cités:
- DE-A1- 19 505 812
- FR-A1- 2 538 120
- FR-A3- 2 839 382

## Description

### DOMAINE TECHNIQUE DE L'INVENTION

L'invention est relative à un capteur de courant mixte comprenant dans un boitier un capteur magnétique de courant ayant un bobinage enroulé autour d'un circuit magnétique et un dispositif de mesure de courant comportant un bobinage de type Rogowski disposé de manière à ce qu'un circuit primaire du capteur magnétique corresponde au circuit primaire dudit dispositif de mesure de courant. Le capteur de courant mixte comprend des moyens électroniques d'acquisition et de mesure du courant électrique, lesdits moyens étant alimentés par le bobinage du capteur magnétique.

L'invention est aussi relative à un procédé de montage du capteur de courant mixte.

### ETAT DE LA TECHNIQUE

L'utilisation de dispositif de mesure de courant comportant des capteurs inductifs de type Rogoswki est largement décrit dans la littérature.

Les dispositifs de mesure de courant de type Rogoswki comprennent un support en matériau amagnétique placé autour d'un conducteur ou ligne de courant dans lequel circule le courant à mesurer. Un fil conducteur est bobiné sur le support pour former un enroulement secondaire. L'ensemble forme un transformateur où ledit conducteur ou ligne de courant constitue un enroulement primaire et ledit enroulement secondaire fournit un signal de mesure. La tension fournie aux bornes de l'enroulement secondaire est directement proportionnelle à l'intensité du courant électrique circulant dans le conducteur ou ligne de courant. L'absence de noyau magnétique risquant d'être saturé, permet une large dynamique de mesure.

Des solutions purement mécanique de maintien des dispositifs de mesure de courant dans les capteurs de courant sont décrites (FR2839382, DE19505812) mais ne prennent pas en compte les problèmes liés à la connexion électrique desdits dispositifs.

Certaines solutions (US4611191, WO01/57543 A1) comportent des bobinages sous la forme de solénoïdes toriques. Le fil électrique peut être alors bobiné sur un support non-conducteur torique de section circulaire ou rectangulaire. Bien que très efficace, les solutions utilisant un tore fermé restent difficiles à industrialiser du fait de la géométrie du tore. En outre, on rencontre des problèmes d'implantation des bobinages sur leur support.

### EXPOSE DE L'INVENTION

L'invention vise donc à remédier aux inconvénients de l'état de la technique, de manière à proposer un dispositif de mesure de courant électrique dont l'industrialisation est simplifiée.

Le capteur de courant mixte selon l'invention est défini par la revendication 1.

Selon un mode de développement de l'invention, le bobinage de type Rogowski est composé une carcasse isolante sur laquelle est bobiné un fil métallique, ladite carcasse isolante comportant des moyens d'encliquetage aptes à collaborer avec les premiers moyens de fixation de la cassette de liaison.

Avantageusement, les moyens d'encliquetage de la carcasse et les premiers moyens de fixation de la cassette de liaison forment un système de type tenon - mortaise.

Selon un mode de développement de l'invention, les seconds moyens de fixation comportent au moins un ergot de centrage et de fixation pour positionner et maintenir par encliquetage la cassette et le dispositif de mesure sur le boitier.

De préférence, le boitier comporte un socle comprenant un premier logement pour les moyens électroniques d'acquisition et de mesure, une des parois dudit logement comportant une ouverture pour le passage de la cassette de liaison.

Avantageusement, le boitier comprend un premier couvercle destiné à être fixé par soudure sur les bords externes des parois du premier logement du socle.

Avantageusement, les moyens électroniques comportent une plaque de circuit imprimé agencée pour se positionner à l'intérieur des parois du logement, la plaque du circuit imprimé comportant des trous autorisant le passage et l'emboitement des broches électriques de la cassette de liaison.

De préférence, le socle comprend un second logement ayant des parois à l'intérieur desquelles sont positionnés le capteur magnétique de courant et le dispositif de mesure de courant.

Avantageusement, le boitier comprend un second couvercle destiné à être fixé par soudure sur les bords externes des parois du second logement du socle.

Le capteur magnétique de courant est connecté aux moyens électroniques d'acquisition et de mesure du courant électrique par des pistes électriques rigides solidaire du socle.

L'invention est relative à un procédé de montage d'un capteur de courant mixte tel que défini ci-dessus. Le procédé selon l'invention comprend les étapes suivantes :
- fixation de la cassette de liaison sur la carcasse isolante du dispositif de mesure de courant, les fils du bobinage étant reliés électriquement à des broches électriques de la cassette ;
- positionnement de l'ensemble formé par la cassette de liaison et la carcasse bobinée dans le logement du socle du boiter, deux ergots de centrage de la cassette autorisant le positionnement et la fixation par encliquetage de la cassette et du dispositif de mesure sur le boitier ;
- fixation dans le socle du boitier du capteur magnétique de courant ;
- soudure électrique des pistes électrique sur le bobinage du capteur magnétique ;
- positionnement de la plaque de circuit imprimé des moyens électroniques d'acquisition à l'intérieur des parois du premier logement ;
- soudure des broches électriques de la cassette et des broches électriques des pistes électrique sur les moyens électroniques d'acquisition ;
- positionnement et soudure d'un premier couvercle sur les bords externes des parois du premier logement ;
- positionnement et soudure d'un second couvercle sur les bords externes des parois du second logement du socle.

Avantageusement, les broches électriques de la cassette de liaison et les broches électriques des pistes électriques sont soudées sur les moyens électroniques d'acquisition par brasure étain laser.

### BREVE DESCRIPTION DES FIGURES

D'autres avantages et caractéristiques ressortiront plus clairement de la description qui va suivre d'un mode particulier de réalisation de l'invention, donné à titre d'exemple non limitatif, et représenté aux dessins annexés sur lesquels :
- la figure 1 représente une vue éclatée d'un capteur de courant électrique mixte selon un mode préféré de réalisation de l'invention ;
- la figure 2 représente une vue éclatée d'un dispositif de mesure de courant d'un capteur de courant électrique mixte selon la figure 1 ;
- la figure 3 représente une vue en perspective d'un dispositif de mesure de courant d'un capteur de courant électrique mixte selon la figure 1 ;
- les figures 4 et 5 représentent des vues en perspective de détail de réalisation du dispositif de mesure de courant selon la figure 3 ;
- la figure 6 représente une vue de détail d'un dispositif de mesure de courant d'un capteur de courant électrique mixte selon la figure 1 ;
- la figure 7 représente une vue en perspective des moyens électroniques d'acquisition et de mesure du courant électrique d'un dispositif de mesure de courant d'un capteur de courant électrique mixte selon la figure 1 ;
- les figures 8 et 9 représentent des vues en perspective d'un capteur de courant électrique mixte en cours de montagne selon la figure 1 ;
- la figure 10 représente un schéma de fonctionnement d'un dispositif de coupure selon un mode de réalisation de l'invention et comportant un capteur de courant électrique mixte selon la figure 1.

### DESCRIPTION DETAILLEE D'UN MODE DE REALISATION

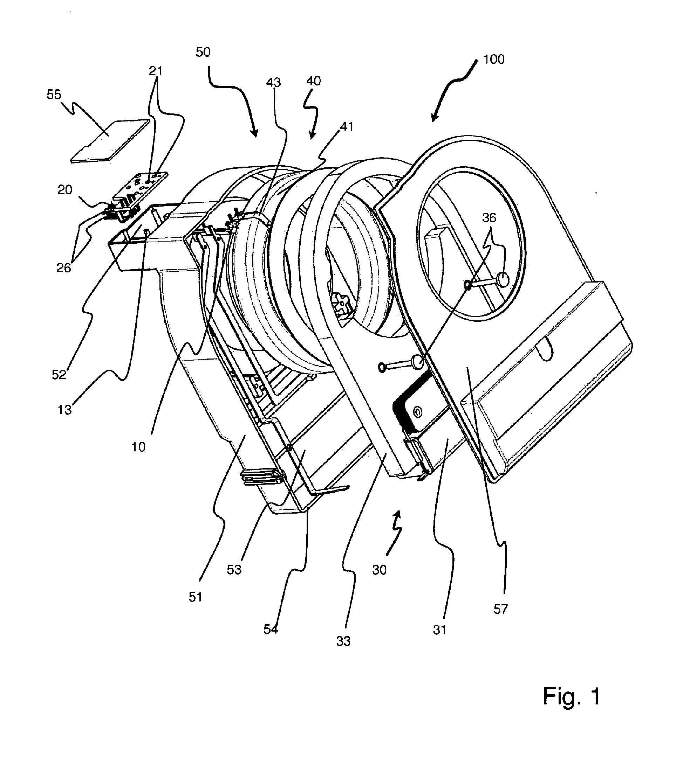

Selon un mode préférentiel tel que représenté sur la figure 1, le capteur de courant mixte 100 comprend un capteur magnétique 30 de courant et un dispositif de mesure de courant 40 assemblés dans un boitier 50.

Le capteur magnétique 30 de courant comporte un bobinage 31 enroulé autour d'un circuit magnétique 33.

Le dispositif de mesure de courant 40 comporte un bobinage 41 de type Rogowski disposé de manière à ce qu'un circuit primaire du capteur magnétique 30 corresponde au circuit primaire dudit dispositif de mesure de courant 40. Le bobinage 41 de type Rogowski est composé une carcasse isolante 44 sur laquelle est bobiné un fil métallique. A titre d'exemple de réalisation, ladite carcasse 43 est de forme circulaire, creuse, en matériau amagnétique, rigide ou semi-rigide, de préférence de section cylindrique ou ovoïde. Le fil métallique enroulé sur la carcasse 43 est de préférence en cuivre ou en un alliage à base de cuivre.

Le boitier 50 est muni d'un évidemment central 90 permettant le passage du conducteur ou ligne de courant 80 sur lequel est effectuée la mesure du courant. Ce conducteur ou ligne de courant forme le circuit primaire du dispositif de mesure de courant 40.

Comme représenté sur les figues 1 et 7, le capteur de courant mixte 100 comprend des moyens électroniques 20 d'acquisition et de mesure du courant électrique. Lesdits moyens sont alimentés par le bobinage 31 du capteur magnétique 30.

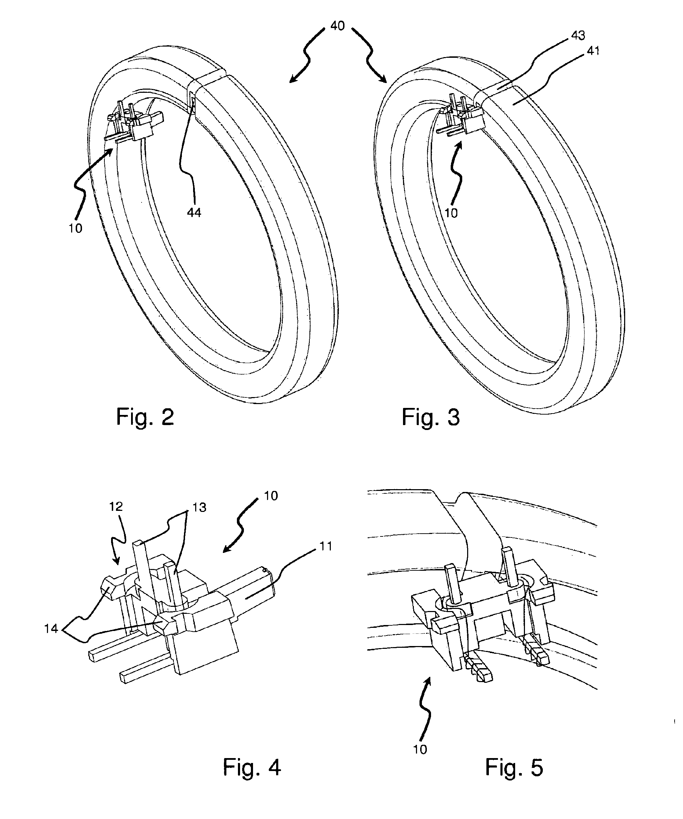

Selon un mode de réalisation tel que représenté sur les figures 2 à 7, le capteur de courant mixte 100 comporte une cassette 10 de liaison comprenant des premiers et seconds moyens de liaison 11, 12.

Le boitier 50 comporte un socle 51 comprenant un premier logement 52 pour les moyens électroniques 20 d'acquisition et de mesure, une des parois dudit logement comportant une ouverture 58 pour le passage de la cassette de liaison 10.

Les premiers moyens de fixation 11 sont agencés pour positionner et maintenir par encliquetage ladite cassette sur dispositif de mesure de courant 40. Le but de l'invention est pouvoir fixer la cassette 10 de liaison sur le dispositif de mesure 40 dans une position reproductible et faciliter ainsi le montage du capteur de courant mixte 100. La carcasse 43 isolante du bobinage 41 de type Rogowski comporte alors des moyens d'encliquetage 44 aptes à collaborer avec les premiers moyens de fixation 11 de la cassette de liaison 10.

Les moyens d'encliquetage 44 de la carcasse 43 et les premiers moyens de fixation 11 de la cassette 10 de liaison forment un système de type tenon - mortaise. Cette liaison présente tout de même de préférence un jeu fonctionnel pour absorber les différents hauteurs de bobinages et afin d'éviter les tensions sur les fils.

Les seconds moyens de fixation 12 de la cassette 10 de liaison sont agencés pour positionner et maintenir par encliquetage ladite cassette et le dispositif de mesure 40 sur le boitier 50. Le but de l'invention est pouvoir fixer l'ensemble formé par une cassette de liaison 10 et le dispositif de mesure 40 au boitier 50 dans une position reproductible et faciliter ainsi le montage du capteur de courant mixte 100.

A titre d'exemple de réalisation tel que représenté sur les figure 4 et 5, les seconds moyens de fixation 12 comportent au moins un ergot 14 de centrage et de fixation pour positionner et maintenir par encliquetage la cassette 10 et le dispositif de mesure 40 sur le boitier 50. Les seconds moyens de fixation comporte de préférence deux ergots 14 de centrage autorisant la fixation de l'ensemble cassette et dispositif de mesure dans un logement 52 du socle 51 du boitier 50.

La cassette de liaison 10 comporte des broches électriques 13 reliées respectivement au bobinage 41 et aux moyens électroniques d'acquisition 20. A titre d'exemple de réalisation, les broches électriques 13 sont soudées aux moyens électroniques d'acquisition 20. Un procédé automatisé de soudure par brasure étain laser peut être utilisé. Les moyens électroniques d'acquisition comportent aussi de préférence plots de connexion destinées à être reliés à une prise.

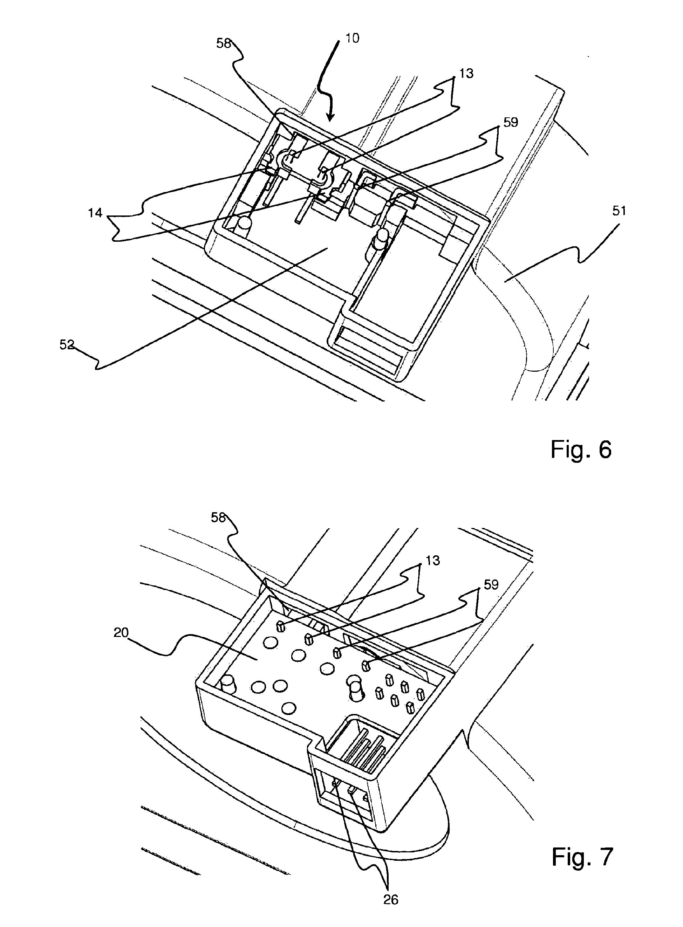

Comme représenté sur la figure 7, les moyens électroniques 20 comportent une plaque de circuit imprimé agencée pour se positionner à l'intérieur des parois du premier logement 52. Ladite plaque du circuit imprimé comportant des trous 21 autorisant le passage par emboitement des broches électriques 13 de la cassette 10 de liaison. Le boitier 50 comprend un premier couvercle 55 plan destiné à être fixé par soudure sur des bords externes des parois du premier logement 52 du socle 51. Les bords externes des parois du premier logement 52 se développent de préférence selon un plan.

Le boitier comporte un socle 51 comprend un second logement 53 ayant des parois à l'intérieur desquelles sont positionnés le capteur magnétique 30 de courant et le dispositif de mesure de courant 40.

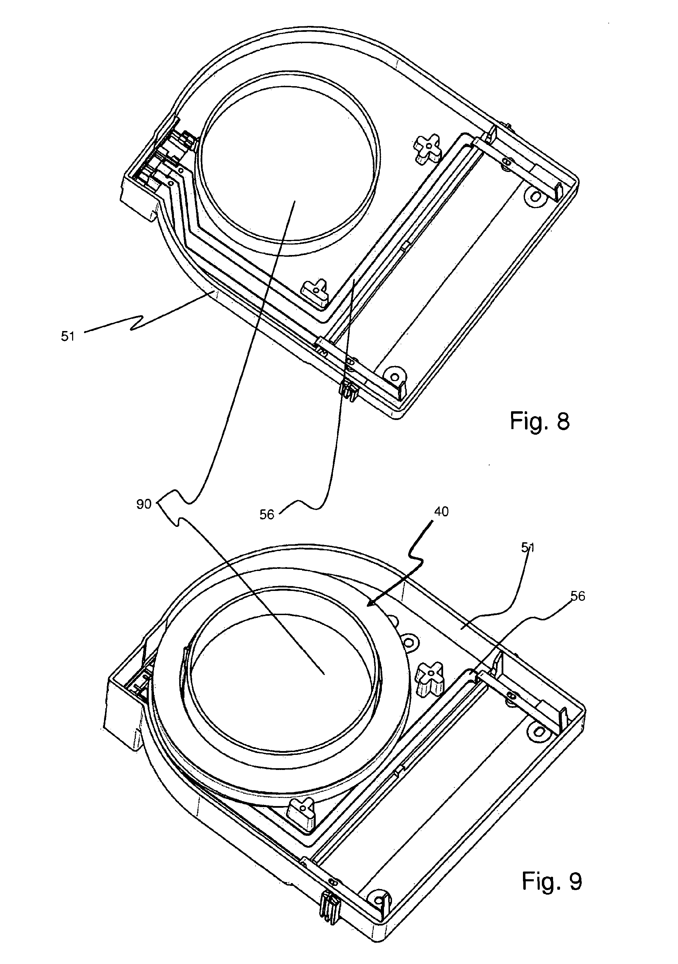

Selon un mode préférentiel de réalisation tel que représenté sur les figures 8 et 9, les bords externes 54 des parois se développant selon un plan. Le boitier 50 comprend un second couvercle 57 plan destiné à être fixé par soudure sur les bords externes 54 des parois du second logement 53 du socle 51.

Le capteur magnétique 30 de courant est connecté aux moyens électroniques 20 d'acquisition et de mesure du courant électrique par des pistes électriques 56 rigides solidaire du socle 51. Les pistes électriques comportent à leurs extrémités des broches 59. Un procédé automatisé de soudure par brasure étain laser peut être utilisé pour souder lesdites broches 59 des pistes électriques 56 à la plaque de circuit imprimé des moyens électroniques d'acquisition 20.

L'invention est aussi relative à un procédé de montage d'un capteur de courant mixte tel que défini ci-dessus. Le procédé consiste dans une première étape à fixer la cassette 10 sur la carcasse 43 isolante du dispositif de mesure de courant 40. Les fils du bobinage 41 de type Rogowski sont reliés électriquement à des broches électriques 13 de la cassette 10.

Dans une seconde étape, l'ensemble formé par la cassette 10 de liaison et la carcasse bobinée 43 est alors positionnée et fixé dans le premier logement 52 du socle du boiter 50. Selon ce mode de réalisation, deux ergots 14 de centrage de la cassette 10 de liaison autorisent le positionnement et la fixation par encliquetage de ladite cassette 10 et du dispositif de mesure 40 sur le boitier 50.

L'étape suivant consiste à fixer dans le socle du boitier 50, le capteur magnétique 30 de courant. Des moyens de fixation 36 permettent de solidariser le capteur magnétique 30 et le dispositif de mesure de courant 40 au socle du boitier 50. Une liaison électrique entre les pistes électriques 56 et le bobinage 31 du capteur magnétique 30. La liaison peut être assurée par exemple par soudure électrique.

Selon un mode de réalisation, les moyens de fixation 36 sont indémontables et peuvent se présenter sous la forme de clous. Grace à ce type de moyens de fixation, l'utilisation habituelle de joint de compensation n'est pas utile pour maintenir le capteur magnétique 30 et le dispositif de mesure de courant 40.

La plaque de circuit imprimé des moyens électroniques d'acquisition 20 est ensuite positionnée à l'intérieur des parois du premier logement 52. Les broches électriques 13 de la cassette 10 de liaison traversent des trous 21 présents sur le circuit. Les broches électriques 59 des pistes électriques 56 traversent aussi des trous 21 dudit circuit. Toutes les broches électriques 13, 59 sont alors soudées de préférence par un procédé automatisé de soudure par brasure étain laser. Un premier couvercle 55 est alors positionné sur les bords externes des parois du premier logement 52. Les bords externes se développent de préférence selon un plan. Le premier couvercle 55 se développant selon un plan est alors soudé sur lesdits bords.

Dans une dernière étape, un second couvercle 57 est positionné sur les bords externes 54 des parois du second logement 53 du socle 51. Le second couvercle se développant selon un plan est alors soudé sur lesdits bords externes 54.

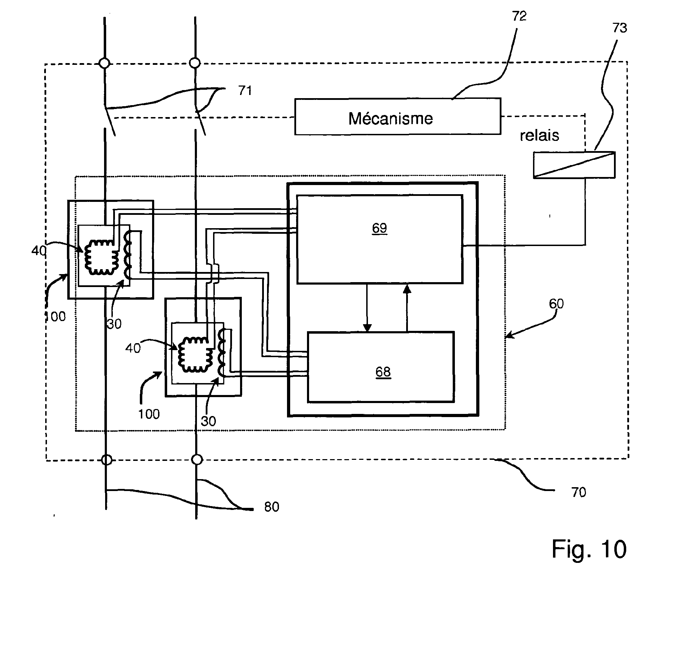

Comme représenté sur la figure 10, un ou plusieurs capteurs de courant mixte 100 peuvent être alors intégrés dans un déclencheur électrique 60 destiné à commander un dispositif de coupure 70 tel qu'un disjoncteur. Le disjoncteur 70 est monté sur des conducteurs ou lignes de courant électrique 80. Le dispositif de coupure 70 comporte un mécanisme d'ouverture 72 de contacts électriques 71.

Les capteurs magnétiques de courant 30 sont alors connectés au boîtier général d'alimentation 68 du déclencheur 60. Ainsi, les moyens de alimentation 68 sont connectés audit capteur de courant mixte 100 pour recevoir au moins un signal l'alimentation.

Les dispositifs de mesure de courant 40 selon l'invention sont reliés aux moyens de traitement généraux 69. Ainsi, les moyens de traitement 69 sont connectés audit capteur de courant mixte 100 pour recevoir au moins un signal représentatif d'un courant primaire circulant dans les lignes 80.

Les moyens généraux de traitement 69 sont eux-mêmes alimentés par le boîtier général d'alimentation 68. Comme cela est représenté sur la figure 10, plusieurs pôles électriques d'une l'installation peuvent comporter chacun un capteur de courant mixte 100 comprenant un capteur magnétique 30 de courant et un dispositif de mesure de courant 40. Si les moyens de traitement généraux 69 reçoivent via les dispositifs de mesure de courant 40, une information de défaut présent sur au moins une des lignes 80, un ordre de commande d'ouverture des contacts 71 peut être envoyé au mécanisme d'ouverture 72 via un relais 73.

## Revendications

1. Capteur de courant mixte (100) comprenant :
- un boitier (50),
- un capteur magnétique (30) de courant ayant un bobinage (31) enroulé autour d'un circuit magnétique (33),
- un dispositif de mesure de courant (40) comportant un bobinage (41) de type Rogowski disposé de manière à ce qu'un circuit primaire du capteur magnétique (30) corresponde au circuit primaire dudit dispositif de mesure de courant (40),
- des moyens électroniques (20) d'acquisition et de mesure du courant électrique, lesdits moyens étant alimentés par le bobinage (31) du capteur magnétique (30) ;
capteur **caractérisé en ce qu'il** comporte une cassette (10) de liaison comprenant
- des premiers moyens de fixation (11) agencés pour positionner et maintenir par encliquetage ladite cassette sur une carcasse isolante (43) du dispositif de mesure (40) ; ladite carcasse comportant des moyens d'encliquetage (44) aptes à collaborer avec les premiers moyens de fixation (11) de la cassette de liaison (10);
- des seconds moyens de fixation (12) agencés pour positionner et maintenir par encliquetage ladite cassette et le dispositif de mesure (40) sur le boitier (50) ;
- des broches électriques (13) reliées respectivement au bobinage de type Rogowski (41) et aux moyens électroniques d'acquisition.

2. Capteur de courant mixte selon la revendication 1, **caractérisé en ce que** le bobinage (41) de type Rogowski est composé une carcasse isolante (44) sur laquelle est bobiné un fil métallique, ladite carcasse comportant des moyens d'encliquetage (44) aptes à collaborer avec les premiers moyens de fixation (11) de la cassette de liaison (10).

3. Capteur de courant mixte selon la revendication 2, **caractérisé en ce que** les moyens d'encliquetage (44) de la carcasse (43) et les premiers moyens de fixation (11) de la cassette (10) de liaison forment un système de type tenon - mortaise.

4. Capteur de courant mixte selon l'une des revendications 1 à 3, **caractérisé en ce que** les seconds moyens de fixation (12) comportent au moins un ergot (14) de centrage et de fixation pour positionner et maintenir par encliquetage la cassette (10) de liaison et le dispositif de mesure (40) sur le boitier (50).

5. Capteur de courant mixte selon l'une quelconque des revendications précédentes, **caractérisé en ce que** le boitier (50) comporte un socle (51) comprenant un premier logement (52) pour les moyens électroniques (20) d'acquisition et de mesure, une des parois dudit logement comportant une ouverture (58) pour le passage de la cassette (10) de liaison.

6. Capteur de courant mixte selon la revendication 5, **caractérisé en ce que** le boitier (50) comprend un premier couvercle (55) destiné à être fixé par soudure sur les bords externes des parois du premier logement (52) du socle (51).

7. Capteur de courant mixte selon la revendication 5, **caractérisé en ce que** les moyens électroniques (20) comportent une plaque de circuit imprimé agencée pour se positionner à l'intérieur des parois du logement (52), la plaque du circuit imprimé comportant des trous (21) autorisant le passage et l'emboitement des broches électriques (13) de la cassette (10) de liaison.

8. Capteur de courant mixte selon l'une quelconque des revendications 5 ou 6, **caractérisé en ce que** le socle (51) comprend un second logement (53) ayant des parois à l'intérieur desquelles sont positionnés le capteur magnétique (30) de courant et le dispositif de mesure de courant (40).

9. Capteur de courant mixte selon la revendication 8, **caractérisé en ce que** le boitier (50) comprend un second couvercle (57) destiné à être fixé par soudure sur les bords externes (54) des parois du second logement (53) du socle (51).

10. Capteur de courant mixte selon l'une quelconque des revendications précédentes, **caractérisé en ce que** le capteur magnétique (30) de courant est connecté aux moyens électroniques (20) d'acquisition et de mesure du courant électrique par des pistes électriques (56) rigides solidaire du socle (51).

11. Procédé de montage d'un capteur de courant mixte selon les revendications précédentes **caractérisé en ce qu'**il comprend les étapes suivantes :
- fixation de la cassette (10) de liaison sur la carcasse (43) isolante du dispositif de mesure de courant (40), les fils du bobinage (41) étant reliés électriquement à des broches électriques (13) de la cassette (10) ;
- positionnement de l'ensemble formé par la cassette (10) de liaison et la carcasse bobinée (43) dans le logement (52) du socle du boiter (50), deux ergots (14) de centrage de la cassette (10) de liaison autorisant le positionnement et la fixation par encliquetage de la cassette (10) de liaison et du dispositif de mesure (40) sur le boitier (50) ;
- fixation dans le socle du boitier (50) du capteur magnétique (30) de courant ;
- soudure électrique des pistes (56) électriques sur le bobinage (31) du capteur magnétique (30)
- positionnement de la plaque de circuit imprimé des moyens électroniques d'acquisition (20) à l'intérieur des parois du premier logement (52) ;
- soudure des broches électriques (13) de la cassette (10) et des broches électriques (59) des pistes (56) électriques sur les moyens électroniques d'acquisition (20) ;
- positionnement et soudure d'un premier couvercle (55) sur les bords externes des parois du premier logement (52) ;
- positionnement et soudure d'un second couvercle (57) sur les bords externes 54 des parois du second logement (53) du socle (51).

12. Procédé de montage selon la revendication précédente **caractérisé en ce que** les broches électriques (13) de la cassette (10) de liaison et les broches électriques (59) des pistes électriques (56) sont soudées sur les moyens électroniques d'acquisition (20) par brasure étain laser.

## Patentansprüche

1. Kombistromwandler (100), umfassend
- ein Gehäuse (50),
- einen Magnetstromwandler (30) mit einer um einen Magnetkreis (33) geführten Wicklung (31),
- eine Strommesseinrichtung (40) mit einer Rogowski-Wicklung (41), die so angeordnet ist, dass ein Primärstromkreis des Magnetwandlers (30) dem Primärstromkreis der genannten Strommesseinrichtung (40) entspricht,
- elektronische Stromerfassungs- und Strommessmitteln (20), deren Energieversorgung über die Wicklung (31) des Magnetwandlers (30) erfolgt, **dadurch gekennzeichnet, dass** der Wandler einen Verbindungsblock (10) mit
- ersten Befestigungsmitteln (11), die dazu ausgelegt sind, den genannten Block (40) durch Aufschnappen auf der genannten Messeinrichtung (40) zu positionieren und zu halten, wobei der genannte Tragkörper Schnappmittel (44) umfasst, die dazu dienen, mit den ersten Befestigungsmitteln (11) des Verbindungsblocks (10) zusammenzuwirken,
- zweiten Befestigungsmitteln (12), die dazu ausgelegt sind, den genannten Block (40) und die genannte Messeinrichtung (40) durch Aufschnappen im Gehäuse (50) zu positionieren und zu halten, sowie mit
- elektrischen Kontaktstiften (13), die mit der Rogowski-Wicklung (41) bzw. den elektronischen Erfassungsmitteln verbunden sind.

2. Kombistromwandler nach Anspruch 1, **dadurch gekennzeichnet, dass** die Rogowski-Wicklung (41) aus einem isolierenden Tragkörper (43) und einem um diesen Tragkörper gewickelten Draht besteht, wobei der Tragkörper Schnappmittel (44) umfasst, die dazu dienen, mit den ersten Befestigungsmitteln (11) des Verbindungsblocks (10) zusammenzuwirken.

3. Kombistromwandler nach Anspruch 2, **dadurch gekennzeichnet, dass** die Schnappmittel (44) des Tragkörpers (43) zusammen mit den ersten Befestigungsmitteln (11) des Verbindungsblocks (10) eine Zapfen-Schlitz-Verbindung bilden.

4. Kombistromwandler nach einem der Ansprüche 1 bis 3, **dadurch gekennzeichnet, dass** die zweiten Befestigungsmittel (12) mindestens einen Zentrier- und Befestigungsstift (14) umfassen, der dazu dient, den Verbindungsblock (10) und die Strommesseinrichtung (40) durch Aufschnappen im Gehäuse (50) zu positionieren und zu halten.

5. Kombistromwandler nach irgendeinem der vorhergehenden Ansprüche, **dadurch gekennzeichnet, dass** das Gehäuse (50) ein Unterteil (51) mit einer ersten Aufnahme (52) für die elektronischen Erfassungs- und Messmittel (20) umfasst, wobei in einer der Wände der genannten Aufnahme eine Öffnung (58) zur Durchführung des Verbindungsblocks (10) ausgebildet ist.

6. Kombistromwandler nach Anspruch 5, **dadurch gekennzeichnet, dass** das Gehäuse (50) eine erste Abdeckung (55) umfasst, die dazu dient, durch Auflöten an den Außenrändern der Wände der ersten Aufnahme (52) des Unterteils (51) befestigt zu werden.

7. Kombistromwandler nach Anspruch 5, **dadurch gekennzeichnet, dass** die elektronischen Mittel (20) eine gedruckte Schaltung umfassen, die dazu ausgelegt ist, zwischen den Wänden der Aufnahme (52) positioniert zu werden, wobei die gedruckte Schaltung Öffnungen (21) umfasst, welche die Durchführung und das Einstecken der elektrischen Kontaktstifte (13) des Verbindungsblocks (10) erlauben.

8. Kombistromwandler nach irgendeinem der Ansprüche 5 oder 6, **dadurch gekennzeichnet, dass** im Unterteil (51) eine zweite Aufnahme (53) mit Wänden ausgebildet, zwischen die der Magnet-Stromwandler (30) und die Strommesseinrichtung (40) eingesetzt werden.

9. Kombistromwandler nach Anspruch 8, **dadurch gekennzeichnet, dass** das Gehäuse (50) eine zweite Abdeckung (57) umfasst, die dazu dient, durch Auflöten auf den Außenrändern (54) der Wände der zweiten Aufnahme (53) des Unterteils (51) befestigt zu werden.

10. Kombistromwandler nach irgendeinem der vorhergehenden Ansprüche, **dadurch gekennzeichnet, dass** der Magnet-Stromwandler (30) über fest mit dem Unterteil (51) verbundene, starre Leiterbahnen (56) mit den elektronischen Stromerfassungs- und Strommessmitteln (20) verbunden sind.

11. Verfahren zum Zusammenbau eines Kombistromwandlers nach den vorhergehenden Ansprüchen, **dadurch gekennzeichnet, dass** es folgende Schritte umfasst:
- Befestigung des Verbindungsblocks (10) auf dem isolierenden Tragkörper (43) der Strommesseinrichtung (40), wobei die Wicklungsdrähte (41) elektrisch mit den Kontaktstiften (13) des Verbindungsblocks (10) verbunden werden,
- Positionierung der aus dem Verbindungsblock (10) und dem umwickelten Tragkörper (43) bestehenden Einheit in der Aufnahme (52) des Unterteils des Gehäuses (50), wobei zwei Zentrierstifte (14) des Verbindungsblocks (10) die Positionierung und Schnappbefestigung des Verbindungsblocks (10) und der Messeinrichtung (40) auf dem Gehäuse (50) erlauben,
- Befestigung des Magnetstromwandlers (30) im Unterteil des Gehäuses (50),
- Verlöten der Leiterbahnen (56) mit der Wicklung (31) des Magnetwandlers (30),
- Positionierung der gedruckten Schaltung der elektronischen Erfassungsmittel (20) zwischen den Wänden der ersten Aufnahme (52),
- Verlöten der elektrischen Kontaktstifte (13) des Verbindungsblocks (10) und der elektrischen Kontaktstifte (59) der Leiterbahnen (56) mit den elektronischen Erfassungsmitteln (20),
- Positionierung und Verlöten einer ersten Abdeckung (55) auf den Außenrändern der Wände der ersten Aufnahme (52),
- Positionierung und Verlöten einer zweiten Abdeckung (57) auf den Außenrändern (54) der Wände der zweiten Aufnahme (53) des Unterteils (51).

12. Zusammenbauverfahren nach dem vorhergehenden Anspruch, **dadurch gekennzeichnet, dass** die elektrischen Kontaktstifte (13) des Verbindungsblocks (10) und die elektrischen Kontaktstifte (59) der Leiterbahnen (56) durch Laserschmelzlöten mithilfe von Lötzinn mit den elektronischen Erfassungsmittel (20) verlötet werden.

## Claims

1. Mixed current sensor (100) comprising:
- a housing (50),
- a magnetic current sensor (30) having a winding (31) wound around a magnetic circuit (33),
- a current measurement device (40) comprising a winding (41) of Rogowski type arranged in such a way that a primary circuit of the magnetic sensor (30) corresponds to the primary circuit of said current measurement device (40),
- electronic means (20) for acquiring and measuring the electrical current, said means being powered by the winding (31) of the magnetic sensor (30);
the sensor being **characterized in that** it comprises a link cassette (10) comprising
- first fastening means (11) arranged to position and hold said cassette by snap-fitting on an insulating frame (43) of the measurement device (40); said frame comprising snap-fitting means (44) suitable for collaborating with the first fastening means (11) of the link cassette (10);
- second fastening means (12) arranged to position and hold said cassette and the measurement device (40) by snap-fitting on the housing (50);
- electrical pins (13) linked respectively to the winding of Rogowski type (41) and to the electronic acquisition means.

2. Mixed current sensor according to Claim 1, **characterized in that** the winding (41) of Rogowski type is made up of an insulating frame (44) on which is wound a metal wire, said frame comprising snap-fitting means (44) suitable for collaborating with the first fastening means (11) of the link cassette (10).

3. Mixed current sensor according to Claim 2, **characterized in that** the snap-fitting means (44) of the frame (43) and the first fastening means (11) of the link cassette (10) form a system of tenor-mortise type.

4. Mixed current sensor according to one of Claims 1 to 3, **characterized in that** the second fastening means (12) comprise at least one centering and fastening lug (14) for positioning and holding the link cassette (10) and the measurement device (40) by snap-fitting on the housing (50).

5. Mixed current sensor according to any one of the preceding claims, **characterized in that** the housing (50) comprises a mounting (51) comprising a first recess (52) for the electronic acquisition and measurement means (20), one of the walls of said recess comprising an opening (58) for the passage of the link cassette (10).

6. Mixed current sensor according to Claim 5, **characterized in that** the housing (50) comprises a first cover (55) intended to be fastened by welding onto the outer edges of the walls of the first recess (52) of the mounting (51).

7. Mixed current sensor according to Claim 5, **characterized in that** the electronic means (20) comprise a printed circuit board arranged to be positioned inside the walls of the recess (52), the board of the printed circuit comprising holes (21) allowing the passage and the fitting of the electrical pins (13) of the link cassette (10).

8. Mixed current sensor according to any one of Claims 5 and 6, **characterized in that** the mounting (51) comprises a second recess (53) having walls inside which the magnetic current sensor (30) and the current measurement device (40) are positioned.

9. Mixed current sensor according to Claim 8, **characterized in that** the housing (50) comprises a second cover (57) intended to be fastened by welding onto the outer edges (54) of the walls of the second recess (53) of the mounting (51).

10. Mixed current sensor according to any one of the preceding claims, **characterized in that** the magnetic current sensor (30) is connected to the electronic means (20) for acquiring and measuring the electrical current by rigid electrical tracks (56) secured to the mounting (51).

11. Method for mounting a mixed current sensor according to the preceding claims, **characterized in that** it comprises the following steps
- fastening the link cassette (10) onto the insulating frame (43) of the current measurement device (40), the wires of the winding (41) being electrically linked to electrical pins (13) of the cassette (10);
- positioning the assembly formed by the link cassette (10) and the wound frame (43) in the recess (52) of the mounting of the housing (50), two centring lugs (14) of the link cassette (10) allowing the positioning and the fitting of the link cassette (10) and of the measurement device (40) by snap-fitting onto the housing (50);
- fastening the magnetic current sensor (30) in the mounting of the housing (50);
- electrically welding the electrical tracks (56) on the winding (31) of the magnetic sensor (30);
- positioning the printed circuit board of the electronic acquisition means (20) inside the walls of the first recess (52);
- welding the electrical pins (13) of the cassette (10) and the electrical pins (59) of the electrical tracks (56) onto the electronic acquisition means (20);
- positioning and welding a first cover (55) onto the outer edges of the walls of the first recess (52);
- positioning and welding a second cover (57) onto the outer edges (54) of the walls of the second recess (53) of the mounting (51).

12. Mounting method according to the preceding claim, **characterized in that** the electrical pins (13) of the link cassette (10) and the electrical pins (59) of the electrical tracks (56) are welded onto the electronic acquisition means (20) by laser tin brazing.
